(19) Europäisches Patentamt
European Patent Office
Office européen des brevets

(11) EP 4 745 592 A1

(12) **EUROPEAN PATENT APPLICATION**
published in accordance with Art. 153(4) EPC

(43) Date of publication:
**20.05.2026 Bulletin 2026/21**

(21) Application number: **23805846.5**

(22) Date of filing: **07.09.2023**

(51) International Patent Classification (IPC):
***G01R 31/367*** *(2019.01)* ***G06F 18/241*** *(2023.01)*
***G06F 18/214*** *(2023.01)*

(52) Cooperative Patent Classification (CPC):
**G01R 31/396; G01R 31/367; G01R 31/392;**
Y04S 10/52

(86) International application number:
**PCT/CN2023/117358**

(87) International publication number:
**WO 2025/010816 (16.01.2025 Gazette 2025/03)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **12.07.2023 CN 202310853073**

(71) Applicant: **National Engineering Research Center of Advanced Energy Storage Materials (Shenzhen) Co., Ltd**
**Shenzhen, Guangdong 518000 (CN)**

(72) Inventors:
- **ZHONG, Faping**
  **Shenzhen, Guangdong 518000 (CN)**
- **ZHAO, Peihong**
  **Shenzhen, Guangdong 518000 (CN)**
- **LI, Wei**
  **Shenzhen, Guangdong 518000 (CN)**
- **TANG, Mingxing**
  **Shenzhen, Guangdong 518000 (CN)**
- **ZHOU, Shuliang**
  **Shenzhen, Guangdong 518000 (CN)**

(74) Representative: **Zaboliene, Reda**
**Metida**
**Business center Vertas**
**Gyneju str. 16**
**01109 Vilnius (LT)**

# (54) DISTRIBUTED NEURAL NETWORK-BASED FAULT DIAGNOSIS METHOD AND SYSTEM FOR ENERGY STORAGE POWER STATION

(57) The present invention designs a fault diagnosis method and system for energy storage power stations based on distributed neural networks. The method includes: obtaining the operating data of various batteries in each energy storage station, and performing preprocessing operations on the data, including data cleaning. and standardization; obtain the diagnostic data of the corresponding energy storage station based on the data preprocessing results; input the preprocessed diagnostic data into the pretrained distributed neural network to diagnose the fault of the energy storage power station. The technical solution proposed in this application can accurately diagnose energy storage power station faults and improve the maintenance efficiency of energy storage power stations.

EP 4 745 592 A1

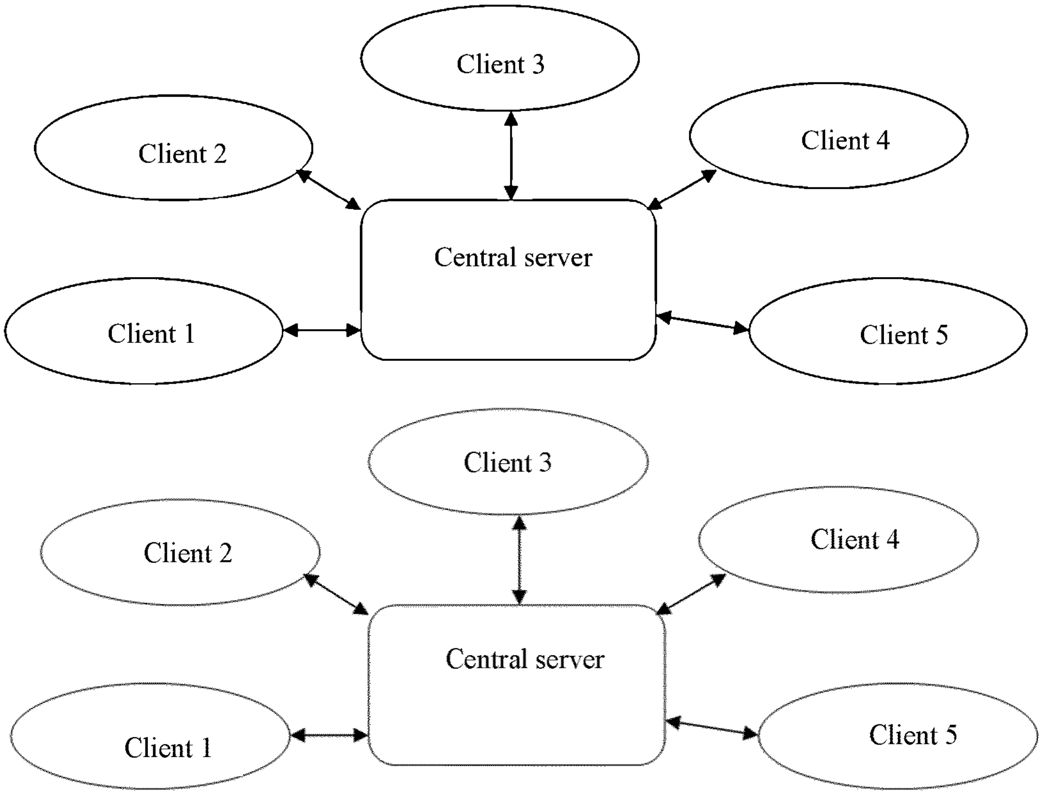
Client 3
Client 2
Client 4
Central server
Client 1
Client 5
Client 3
Client 2
Client 4
Central server
Client 1
Client 5

FIG. 1

## Description

## Technical field

The present invention relates to the field of energy storage technology, and in particular to a method and system for diagnosing energy storage power station faults based on artificial intelligence algorithms.

## Background

In recent years, the installed capacity of lithium battery energy storage systems at home and abroad has grown rapidly. Since the internal and external characteristics of battery energy storage power station equipment are different from conventional electrical equipment and have typical electrochemical dynamic evolution characteristics, performance maintenance cannot copy the operation and maintenance of existing conventional electrical equipment. procedures. Improper operation and maintenance will cause problems such as battery performance degradation, excessive energy consumption, serious loss of life, and even potential safety hazards. At present, the input quantities of the traditional power management system (battery management system, BMS) mainly include voltage (U), current (I) and temperature (T), and the temperature is the external temperature of the battery. These parameters are all external characteristic parameters of the battery, but lithium-ion batteries are highly complex electrochemical systems. It is often difficult to accurately identify internal battery faults (such as overcharge, over-discharge, over-temperature, internal short circuit, external failure) by relying solely on the above-mentioned external characteristic parameters. Short circuit, leakage, extrusion deformation, etc.). If these faults cannot be identified in advance, risks such as sudden power loss or fire and explosion of the battery system may occur during use. Therefore, assessing and predicting battery health status is crucial to the healthy and stable operation of the system. Accurate status assessment and trend analysis can help identify problem batteries, facilitate system maintenance, and ensure the health and stability of the energy storage system.

For the usage scenario of battery fault diagnosis, due to the electrochemical characteristics of lithium battery energy storage power stations and the diversity of working state parameters of working power stations, traditional artificial intelligence-based learning prediction methods face the problem of small samples, difficult fault diagnosis, and different models for the same model. There is a problem of large accuracy differences in the working environment of energy storage stations. At the same time, equipment operation data involves business secrets such as the company's production parameters, which is not suitable for transmission and sharing. Therefore, it is difficult to establish an effective prediction model and realize the prediction of energy storage power stations. Accurate detection of faults.

## SUMMARY

In order to solve the above existing problems and defects, the present invention provides an energy storage power station fault diagnosis method and system based on a distributed neural network. The method includes: obtaining the operating data of various batteries in each energy storage station, and analyzing the data. Perform preprocessing operations, including data cleaning and standardization; obtain diagnostic data of the corresponding energy storage station based on the data preprocessing results; input the preprocessed diagnostic data into the pretrained distributed neural network to diagnose energy storage power station faults. S1. Obtain the operating data of various batteries in each energy storage station and perform preprocessing operations on the data;

Collect the operating parameters of each power station, and perform data cleaning and standardization operations; the operating parameters include battery voltage data, battery current data, battery Coulombic efficiency, battery temperature data, and power station environmental data; the power station environmental data includes: power station ambient temperature, power station Environmental humidity and power station light intensity data.

The cleaning operation of the work operation data includes: deleting abnormal data points and interpolation operations; if the amplitude of the operation parameter point is greater than or less than 6% of the average amplitude, it is regarded as an abnormal data point, and the work operation parameters of the point are Delete; data interpolation operations include cubic spline interpolation to interpolate data points.

For data standardization operations, use the following calculation formula to standardize the workstation operating parameters:

$$\mathrm{difStid} = \frac{(x_i - \bar{x})}{V_M} \qquad (1)$$

In the formula,difStidis the standard score of operating parameters of each power station,$x_i$ is the i-th parameter value of each power station operating parameter, where the parameter values include: voltage, current, battery Coulomb

efficiency, battery temperature, and power station environmental parameters; $\bar{x}$ is the average value of battery operating parameters in each power station, $V_M$ is the standard deviation of the corresponding power station operating parameters; The power station environmental parameters $x_k$ are weighted parameters of the power station temperature, humidity and illumination amplitude;

The power station environmental parameters $x_k$ can be expressed as the following formula:

$$x_k=k_1C_1+ k_2C_2+ k_3C_3 \qquad (2)$$

Among of them ,$k_i$ represents the weighting coefficient of the temperature, humidity, and illumination amplitude of the power station;$C_1$, $C_2$, $C_3$respectively represent the standardized value of the power station's ambient temperature, humidity, and light.

The calculation formula for the Coulombic efficiency of the battery is as follows:

$$C_{e,i} = \frac{Q_{discharge,i}}{Q_{charge,i}} \qquad (3)$$

In the formula,$C_{e,i}$ is the Coulomb efficiency of the i-th battery in the power station,$Q_{discharge,i}$ is the discharge capacitance of the i-th battery in each power station, $Q_{charge,i}$ is the charging capacitance of the i-th battery in each power station.

S2. Use the preprocessed power station operating parameters to use the feature extraction network in each power station client to extract power station operating fault features.

S21. Establish a client-central server distributed learning framework;

Before feature extraction of power station operating parameters, a distributed neural network learning architecture needs to be established;

Establish a central server on the equipment management side and build client servers on the user side of each power station. The number of client servers is greater than or equal to 5.

Construct an initial feature extraction network model in the central server, and randomly initialize the model parameters; before sending the initial feature extraction network to the client, the parameters are randomly initialized once;

S22. Feature extraction model training;

The client server uses the preprocessed operating parameters to start model training on the randomly initialized model and obtains the trained model parameters.

In the feature extraction network model training stage, all operating parameters of each power station are used as input data of the feature extraction network to implement the training of the feature extraction network model.

S23. Parameter update and aggregation of the feature extraction model;

After each client completes an iterative training, the model parameters are uploaded to the central server. The central server aggregates the model parameters of each power station client based on the power station scale coefficient.

S24. The feature extraction network completes training;

When the model parameters of each client server are accepted to meet the suspension condition, the training of the feature extraction network of each client server is stopped.

The feature extraction network is the power residual awareness network BRAN (BatteryResidual-aware Network). The feature extraction network contains five input layers, each of which corresponds to voltage, current, battery Coulombic efficiency, battery temperature, environment (temperature, humidity, Lighting); each input layer includes 5 convolutional layers and 4 deconvolution layers. Each deconvolution layer is connected to the power residual sensing module to realize feature extraction of power station power energy.

The BRAN network implements parameter aggregation at the central server, and uses the following loss function to update and optimize the BRAN feature extraction network;

$$L_{tot}=\alpha\ L_{Dis}+\beta L_{Sca}+\gamma L_{Var}; \qquad (4)$$

$$L_{Dis} = \frac{1}{N}\sum_{i=1}^{N}\|K_{s1}(I_i) - K_{s2}(I_i)\| \qquad (5)$$

$$L_{Sig} = \frac{1}{N}\sum_{i=1}^{N}\beta_i \log\frac{(G_{s1}(I_i))}{(G_N(I_i))} \quad (6)$$

$$L_{Ass} = \frac{1}{N}\sum_{i=1}^{N}\gamma_{i,j}\|V_{s1}(I_i - I_{i-1}) - V_{s2}(I_i - I_{i-1})\|_2 \quad (7)$$

Among them, $L_{tot}$ is the total loss function of the BRAN network, $L_{Dis}$ is the feature distance loss function, $L_{Sca}$ is the power plant scale loss function, $L_{Var}$ is the model parameter variance loss function; $\alpha$, $\beta$, $\gamma$ are the characteristic distance coefficient, power plant scale coefficient and parameter variance coefficient respectively.; Nis the number of models; $I_i$ is the operating parameter; $K_{s1}$, $K_{s2}$ Model output features; $G_{s1}$, $G_N$ is a function of power plant scale; $V_{s1}$, $V_{s2}$ is the variance between client model parameters;

S3. Use the aggregate feature extraction network to implement feature extraction of a single operating parameter on the client server of each power station, and train the fault diagnosis classification model;
S31. Construct a client-central server distributed fault diagnosis network model architecture;
Build a fault diagnosis network in the corresponding client and central server; build a fault diagnosis network model in the central server, and randomly initialize the model parameters; before sending the initial fault diagnosis network to the client, randomly initialize the parameters ;
S31. Fault diagnosis model training;
The training of the fault diagnosis model is divided into K rounds; in each round of training, the client feature extraction network only analyzes one operating parameter among voltage, current, battery Coulombic efficiency, battery temperature, and environment (temperature, humidity, light). Carry out feature extraction and input the extracted features into the fault diagnosis model for fault classification and recognition training; after each client completes this round of training, upload the model parameters to the central server to implement model parameter aggregation;
The weighted aggregation formula of the model parameters for this round is as follows:

$$J_i = h_{1i}(P_1 + P_2 + P_3 + P_4) + h_{2i}P_5 \quad (8)$$

Among of them ,$J_i$ is the aggregate model parameter, $h_{1i}$, $h_{2i}$ is the aggregation coefficient; $P_1$, $P_2$, $P_3$ , $P_4$ are model parameters for feature extraction and fault diagnosis, classification and identification of one of the operating parameters of voltage, current, battery Coulombic efficiency, and battery temperature;$P_5$ s for feature extraction and fault diagnosis, classification and identification of environmental parameters. model parameters;
In the next round of training, the client will no longer perform feature extraction on the operating parameters of the previous round, that is, it will replace another power station operating parameter to achieve feature extraction and classification diagnosis;
Until O rounds of training are completed or each client has completed feature extraction and classification diagnosis of voltage, current, battery Coulombic efficiency, battery temperature, and environmental (temperature, humidity, light) operating parameters, the iterative training will stop. During each iteration process Use the cross-entropy loss function to implement updated training of the model.

The fault diagnosis classification network is a multi-classification FCN network containing 5 fully connected layers.

S4. Collect the operating parameters of the power station and input them into the feature extraction network and fault diagnosis network to realize fault diagnosis of the power station.

Collect the voltage, current, battery Coulomb efficiency, battery temperature, and environmental (temperature, humidity, light) operating parameters in the power station, input them into the feature extraction network, and input the extracted features into the multi-classification FCN network to implement fault diagnosis of the power station.

The method also includes an online model update step, in which the collected operating parameters are preprocessed and then the feature extraction network of the central server and the multi-classification FCN network are re-trained and model updated online.

The present invention proposes a fault diagnosis method and system for energy storage power stations based on distributed neural networks. The present invention at least has the following beneficial effects: model training is performed locally at each power station through distributed neural networks, thereby avoiding the leakage of power station production data and protecting While ensuring the security and privacy of power station data, it solves the problems of difficult data collection and low data accuracy in equipment manufacturing enterprises; building a BRAN feature extraction network to extract deep features of power station power energy and improving power station fault diagnosis accuracy; building a fault

diagnosis classification network The rotation training mechanism obtains a high-precision and robust fault diagnosis and classification network, which improves the classification and recognition accuracy of the fault diagnosis model in different scenarios.

## BRIEF DESCRIPTION OF THE DRAWINGS

Figure 1 is the client-server architecture diagram of distributed neural network;
Figure 2 is a network structure diagram of the power residual sensing module of the improved BRAN network.

## DETAILED DESCRIPTION

The present invention will now be further described with reference to the embodiments and drawings:

S1. Obtain the operating data of various batteries in each energy storage station and perform preprocessing operations on the data;
Collect the operating parameters of each power station, and perform data cleaning and standardization operations; the operating parameters include battery voltage data, battery current data, battery Coulombic efficiency, battery temperature data, and power station environmental data; the power station environmental data includes: power station ambient temperature, power station Environmental humidity and power station light intensity data.

The cleaning operation of the work operation data includes: deleting abnormal data points and interpolation operations; if the amplitude of the operation parameter point is greater than or less than 6% of the average amplitude, it is regarded as an abnormal data point, and the work operation parameters of the point are Delete; data interpolation operations include cubic spline interpolation to interpolate data points.

In some embodiments, cleaning data: Cleaning data refers to removing abnormal data points, such as abnormal values caused by acquisition equipment failure or transmission errors. Specifically, we can use statistical methods or threshold decisions to detect abnormal data points and eliminate them. For example, suppose we collect a set of battery temperature data as follows:
[25, 27, 30, 35, -50, 28, 29]

In this example, -50 is an outlier and we can identify it as an outlier data point and remove it from the dataset.

Interpolation operation: The interpolation operation is to fill in the missing data points. During battery operation, conditions such as sensor failure or communication interruptions may occur, causing some data points to be missing. To maintain data continuity, we can use interpolation methods to fill in these missing data points. Common interpolation methods include linear interpolation, polynomial interpolation, spline interpolation, etc.

For example, assume we collected the following battery voltage data:
[3.2, 3.5, None, 3.8, 4.1]

In this example, the third data point in the dataset is missing. We can use the linear interpolation method to perform interpolation calculations based on previous and later data points. According to the linear interpolation formula, the value of the missing data point can be calculated to be 3.65. The result after filling the data is as follows:
[3.2, 3.5, 3.65, 3.8, 4.1]

Through data cleaning and interpolation operations, we can reduce the interference of abnormal data on subsequent analysis and modeling, and ensure the integrity and continuity of the data. These preprocessing steps help improve data quality and provide reliable input data for subsequent fault diagnosis models.

For data standardization operations, use the following calculation formula to standardize the workstation operating parameters:

$$\mathrm{difStid} = \frac{(x_i - \bar{x})}{V_M} \qquad (1)$$

In the formula,difStidis the standard score of operating parameters of each power station,$x_i$ is the i-th parameter value of each power station operating parameter, where the parameter values include: voltage, current, battery Coulomb efficiency, battery temperature, and power station environmental parameters; $\bar{x}$ is the average value of battery operating parameters in each power station, $V_M$ is the standard deviation of the corresponding power station operating parameters; The power station environmental parameters $x_k$ are weighted parameters of the power station temperature, humidity and illumination amplitude;

The power station environmental parameters $x_k$ can be expressed as the following formula:

$$x_k=k_1C_1+ k_2C_2+ k_3C_3 \quad (2)$$

Among of them ,$k_i$ represents the weighting coefficient of the temperature, humidity, and illumination amplitude of the power station;$C_1$ , $C_2$, $C_3$ respectively represent the standardized value of the power station's ambient temperature, humidity, and light.

The calculation formula for the Coulombic efficiency of the battery is as follows:

$$C_{e,i} = \frac{Q_{discharge,i}}{Q_{charge,i}} \quad (3)$$

In the formula,$C_{e,i}$ is the Coulomb efficiency of the i-th battery in the power station,$Q_{discharge,i}$ is the discharge capacitance of the i-th battery in each power station, $Q_{charge,i}$ is the charging capacitance of the i-th battery in each power station.

S2. Use the preprocessed power station operating parameters to use the feature extraction network in each power station client to extract power station operating fault features.

S21. Establish a client-central server distributed learning framework;
Before feature extraction of power station operating parameters, a distributed neural network learning architecture needs to be established;

Establish a central server on the equipment management side and build client servers on the user side of each power station. The number of client servers is greater than or equal to 5.

Construct an initial feature extraction network model in the central server, and randomly initialize the model parameters; before sending the initial feature extraction network to the client, the parameters are randomly initialized once;

S22. Feature extraction model training;
The client server uses the preprocessed operating parameters to start model training on the randomly initialized model and obtains the trained model parameters.

**In** the feature extraction network model training stage, all operating parameters of each power station are used as input data of the feature extraction network to implement the training of the feature extraction network model.

S23. Parameter update and aggregation of the feature extraction model;

After each client completes an iterative training, the model parameters are uploaded to the central server. The central server is based on the power plant scale coefficient$\beta_i$ Realize the aggregation of model parameters of each power station client.

S24. The feature extraction network completes training;
When the model parameters of each client server are accepted to meet the suspension condition, the training of the feature extraction network of each client server is stopped.

The feature extraction network is the power residual awareness network BRAN (BatteryResidual-aware Network). The feature extraction network contains five input layers, each of which corresponds to voltage, current, battery Coulombic efficiency, battery temperature, environment (temperature, humidity, Lighting); each input layer includes 5 convolutional layers and 4 deconvolution layers. Each deconvolution layer is connected to the power residual sensing module to realize feature extraction of power station power energy. The schematic diagram of its overall network structure is shown in Figure 2:

The Mixing module is the weighted value of voltage, current, battery Coulombic efficiency, battery temperature, and environment (temperature, humidity, light) after passing through 5 layers of convolution layers and 4 layers of deconvolution layers, that is, to obtain weighted fusion features, as shown in Figure 2 is represented by M; the perception layer implements feature sensing operations on voltage, current, battery Coulombic efficiency, and battery temperature, implements feature sensing operations on the internal operating parameters of the battery, and extracts the deep operating features inside the battery; finally, the weighted fusion features and perception Deep fusion of the deep sensing features of different layers is performed to obtain the deep features of the power station's electric energy;
The BRAN network implements parameter aggregation at the central server, and uses the following loss function to update and optimize the BRAN feature extraction network;

$$L_{tot}=\alpha\ L_{Dis}+\beta L_{Sca}+\gamma L_{Var}; \quad (4)$$

$$L_{Dis} = \frac{1}{N}\sum_{i=1}^{N}\|K_{s1}(I_i) - K_{s2}(I_i)\| \quad (5)$$

$$L_{Sig} = \frac{1}{N}\sum_{i=1}^{N}\beta_i \log\frac{(G_{s1}(I_i))}{(G_N(I_i))} \quad (6)$$

$$L_{Ass} = \frac{1}{N}\sum_{i=1}^{N}\gamma_{i,j}\|V_{s1}(I_i - I_{i-1}) - V_{s2}(I_i - I_{i-1})\|_2 \quad (7)$$

Among them, $L_{tot}$ is the total loss function of the BRAN network, $L_{Dis}$ is the feature distance loss function, $L_{Sca}$ is the power plant scale loss function, $L_{Var}$ is the model parameter variance loss function; $\alpha$, $\beta$, $\gamma$ are the characteristic distance coefficient, power plant scale coefficient and parameter variance coefficient respectively.; Nis the number of models; $I_i$ is the operating parameter; $K_{s1}$, $K_{s2}$ Model output features; $G_{s1}$, $G_N$ is a function of power plant scale; $V_{s1}$, $V_{s2}$ is the variance between client model parameters;

S3. Use the aggregate feature extraction network to implement feature extraction of a single operating parameter on the client server of each power station, and train the fault diagnosis classification model.

S31. Construct a client-central server distributed fault diagnosis network model architecture;

Build a fault diagnosis network in the corresponding client and central server; build a fault diagnosis network model in the central server, and randomly initialize the model parameters; before sending the initial fault diagnosis network to the client, randomly initialize the parameters ;

S31. Fault diagnosis model training;

The training of the fault diagnosis model is divided into K rounds; in each round of training, the client feature extraction network only analyzes one operating parameter among voltage, current, battery Coulombic efficiency, battery temperature, and environment (temperature, humidity, light). Carry out feature extraction and input the extracted features into the fault diagnosis model for fault classification and recognition training; after each client completes this round of training, upload the model parameters to the central server to implement model parameter aggregation; The weighted aggregation formula of the model parameters for this round is as follows:

$$J_i = h_{1i}(P_1 + P_2 + P_3 + P_4) + h_{2i}P_5 \quad (8)$$

Among of them ,$J_i$ is the aggregate model parameter, $h_{1i}$, $h_{2i}$ is the aggregation coefficient; $P_1$, $P_2$, $P_3$ , $P_4$ are model parameters for feature extraction and fault diagnosis, classification and identification of one of the operating parameters of voltage, current, battery Coulombic efficiency, and battery temperature;$P_5$ s for feature extraction and fault diagnosis, classification and identification of environmental parameters. model parameters;

In the next round of training, the client will no longer perform feature extraction on the operating parameters of the previous round, that is, it will replace another power station operating parameter to achieve feature extraction and classification diagnosis;

Until O rounds of training are completed or each client has completed feature extraction and classification diagnosis of voltage, current, battery Coulombic efficiency, battery temperature, and environmental (temperature, humidity, light) operating parameters, the iterative training will stop. During each iteration process Use the cross-entropy loss function to implement updated training of the model.

The fault diagnosis classification network is a multi-classification FCN network containing 5 fully connected layers.

S4. Collect the operating parameters of the power station and input them into the feature extraction network and fault diagnosis network to realize fault diagnosis of the power station.

Collect the voltage, current, battery Coulomb efficiency, battery temperature, and environmental (temperature, humidity, light) operating parameters in the power station, input them into the feature extraction network, and input the extracted features into the multi-classification FCN network to implement fault diagnosis of the power station.

This embodiment also includes an online model update step, which preprocesses the collected operating parameters and then performs online training and model update on the feature extraction network and the multi-classification FCN network of the central server.

Those skilled in the art should understand that the embodiments of the present invention described in the above description and drawings are only examples and do not limit the present invention. The object of the present invention has been completely and effectively achieved. The functional and structural principles of the present invention have been shown and described in the embodiments, and the implementation method of the present invention may have any form or

modification without departing from the principles.

## Claims

1. A fault diagnosis method for energy storage power stations based on distributed neural networks, which is **characterized by** including:

S1. Obtain the operating data of various batteries in each energy storage station and perform preprocessing operations on the data;
S2. Use the preprocessed power station operating parameters to use the feature extraction network in each power station client to extract power station operating fault features;
S21. Establish a client-central server distributed learning framework;
S22. Feature extraction model training;
In the feature extraction network model training stage, all operating parameters of each power station are used as input data of the feature extraction network to implement the training of the feature extraction network model;
S23. Parameter update and aggregation of the feature extraction model;
After each client completes an iterative training, the model parameters are uploaded to the central server. The central server is based on the power plant scale coefficient$\beta_i$ Realize the aggregation of model parameters of each power station client;
S24. The feature extraction network completes training;
When the model parameters of each client server are accepted to meet the suspension condition, the training of the feature extraction network of each client server is stopped;
The feature extraction network model is the electric energy residual sensing network BRAN. The feature extraction network model includes the electric energy residual sensing module; the electric energy residual sensing module includes the Mixing module and the sensing layer; the Mixing module is voltage, current, battery Coulomb efficiency, and battery temperature. , the weighted values of the environment (temperature, humidity, light) after passing through 5 layers of convolution layers and 4 layers of deconvolution layers are used to obtain weighted fusion features; the perception layer implements feature sensing operations on voltage, current, battery Coulombic efficiency, and battery temperature. , realize the feature sensing operation of the internal operating parameters of the battery, and extract the deep operating features inside the battery; finally, the weighted fusion features are deeply fused with the deep sensing features of the sensing layer to obtain the deep features of the power station's electric energy; the environmental parameters include ambient temperature, environment Humidity, ambient light data;
The BRAN network implements parameter aggregation at the central server, and uses the following loss function to update and optimize the BRAN feature extraction network;

$$L_{tot}=\alpha\ L_{Dis}+\beta L_{Sca}+\gamma L_{Var}; \quad (4)$$

$$L_{Dis}=\frac{1}{N}\sum_{i=1}^{N}\|K_{s1}(I_i)-K_{s2}(I_i)\| \quad (5)$$

$$L_{Sig}=\frac{1}{N}\sum_{i=1}^{N}\beta_i\log\frac{(G_{s1}(I_i))}{(G_N(I_i))} \quad (6)$$

$$L_{Ass}=\frac{1}{N}\sum_{i=1}^{N}\gamma_{i,j}\|V_{s1}(I_i-I_{i-1})-V_{s2}(I_i-I_{i-1})\|_2 \quad (7)$$

Among them, $L_{tot}$ is the total loss function of the BRAN network, $L_{Dis}$ is the feature distance loss function, $L_{Sca}$ is the power plant scale loss function, $L_{Var}$ is the model parameter variance loss function; $\alpha$, $\beta$, $\gamma$ are the characteristic distance coefficient, power plant scale coefficient and parameter variance coefficient respectively.; Nis the number of models; $I_i$ is the operating parameter; $K_{s1}$, $K_{s2}$ Model output features; $G_{s1}$, $G_N$ is a function of power plant scale; $V_{s1}$, $V_{s2}$ is the variance between client model parameters;
S3. Use the aggregate feature extraction network to implement feature extraction of a single operating parameter on the client server of each power station, and train the fault diagnosis classification model;

S4. Collect the operating parameters of the power station and input them into the feature extraction network and fault diagnosis network to realize fault diagnosis of the power station.

2. A method for fault diagnosis of energy storage power stations based on distributed neural networks according to claim 1, **characterized in that** preprocessing the data includes the following preprocessing process:

Cleaning operation of work operation data includes: deletion of abnormal data points and interpolation operations; if the amplitude of the operation parameter point is greater than or less than 6% of the average amplitude, it is regarded as an abnormal data point, and the work of the abnormal data point Operation parameters are deleted; data interpolation operations include cubic spline interpolation method to interpolate data points;
For data standardization operations, use the following calculation formula to standardize the workstation operating parameters:

$$\mathrm{difStid} = \frac{(x_i - \bar{x})}{V_M} \qquad (1)$$

In the formula,difStidis the standard score of operating parameters of each power station,$x_i$ is the i-th parameter value of each power station operating parameter, where the parameter values include: voltage, current, battery Coulomb efficiency, battery temperature, and power station environmental parameters; $\bar{x}$ is the average value of battery operating parameters in each power station, $V_M$ is the standard deviation of the corresponding power station operating parameters.

3. An energy storage power station fault diagnosis method based on distributed neural network according to claim 2, **characterized in that** the power station environmental parameters further include:

The environmental parameters of the power station include the temperature of the power station, the humidity of the power station and the light intensity of the power station;
The environmental parameters$x_k$ of the power station are expressed as follows:

$$x_k = k_1C_1 + k_2C_2 + k_3C_3 \qquad (2)$$

Among of them, $k_i$ The weighting coefficient representing the temperature, humidity, and illumination amplitude of the power station;$C_1$, $C_2$, $C_3$Respectively represent the standardized value of the power station ambient temperature, the standardized value of humidity and the standardized value of light.

4. A fault diagnosis method for energy storage power stations based on distributed neural networks according to claim 2, **characterized in that** the Coulombic efficiency of the battery is:

The calculation formula for the Coulombic efficiency of the battery is as follows:

$$C_{e,i} = \frac{Q_{discharge,i}}{Q_{charge,i}} \qquad (3)$$

In the formula,$C_{e,i}$ is the Coulomb efficiency of the i-th battery in the power station,$Q_{discharge,i}$ is the discharge capacitance of the i-th battery in each power station, $Q_{charge,i}$ is the charging capacitance of the i-th battery in each power station.

5. An energy storage power station fault diagnosis method based on distributed neural network according to claim 1, **characterized in that** the electric energy residual sensing network BRAN includes:
The feature extraction network contains five input layers, each of which corresponds to voltage, current, battery Coulombic efficiency, battery temperature, and environment (temperature, humidity, light); each input layer includes 5 convolutional layers and 4 deconvolution layers. layer, each deconvolution layer is connected to the electric energy residual sensing module to realize feature extraction of the power station's electric energy.

6. A fault diagnosis method for energy storage power stations based on distributed neural networks according to claim 1, **characterized in that** training the fault diagnosis model includes the following steps:

S31. Construct a client-central server distributed fault diagnosis network model architecture;
Build a fault diagnosis network in the corresponding client and central server; build a fault diagnosis network model in the central server, and randomly initialize the model parameters; before sending the initial fault diagnosis network to the client, randomly initialize the parameters ;
S31. Fault diagnosis model training;
The training of the fault diagnosis model is divided into K rounds; in each round of training, the client feature extraction network only analyzes one operating parameter among voltage, current, battery Coulombic efficiency, battery temperature, and environment (temperature, humidity, light). Carry out feature extraction and input the extracted features into the fault diagnosis model for fault classification and recognition training; after each client completes this round of training, upload the model parameters to the central server to implement model parameter aggregation;
In the next round of training, the client will no longer perform feature extraction on the operating parameters of the previous round, that is, it will replace another power station operating parameter to achieve feature extraction and classification diagnosis;
Until O rounds of training are completed or each client has completed feature extraction and classification diagnosis of voltage, current, battery Coulombic efficiency, battery temperature, and environmental (temperature, humidity, light) operating parameters, the iterative training will stop. During each iteration process Use the cross-entropy loss function to implement updated training of the model.

**7.** A method for fault diagnosis of energy storage power stations based on distributed neural networks according to claim 6, **characterized in that** the method for the central server to perform weighted aggregation of model parameters includes:

Use the following weighted aggregation formula to implement weighted aggregation of each client model:

$$J_i=h_{1i}(P_1+ P_2+ P_3 + P_4)+h_{2i}P_5 \quad (8)$$

Among of them, $J_i$ is the aggregate model parameter, $h_{1i}$, $h_{2i}$ is the aggregation coefficient;$P_1$, $P_2$, $P_3$ , $P_4$ It is a model parameter for feature extraction and fault diagnosis and classification identification of one of the operating parameters of voltage, current, battery Coulombic efficiency, and battery temperature;$P_5$ is a model parameter for feature extraction of environmental parameters and fault diagnosis, classification and identification.

**8.** A fault diagnosis method for energy storage power stations based on distributed neural networks according to claim 6, **characterized in that** the fault diagnosis model is a multi-classification FCN network including 5 fully connected layers.

**9.** A fault diagnosis method for energy storage power stations based on distributed neural networks according to claim 8, **characterized in that**: the feature extraction model and the fault diagnosis model also include a model online update step, which preprocesses the collected operating parameters. Afterwards, the feature extraction network of the central server and the multi-classification FCN network were re-trained and model updated online.

**10.** A fault diagnosis system for energy storage power stations based on distributed neural networks, **characterized in that** the system implements the fault diagnosis of energy storage power stations based on distributed neural networks according to any one of claims 1 to 9 method.

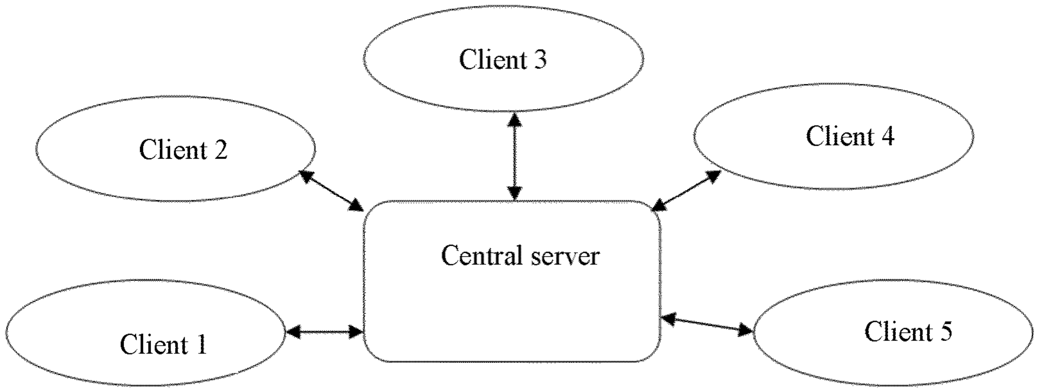
Client 3
Client 2
Client 4
Central server
Client 1
Client 5

FIG. 1

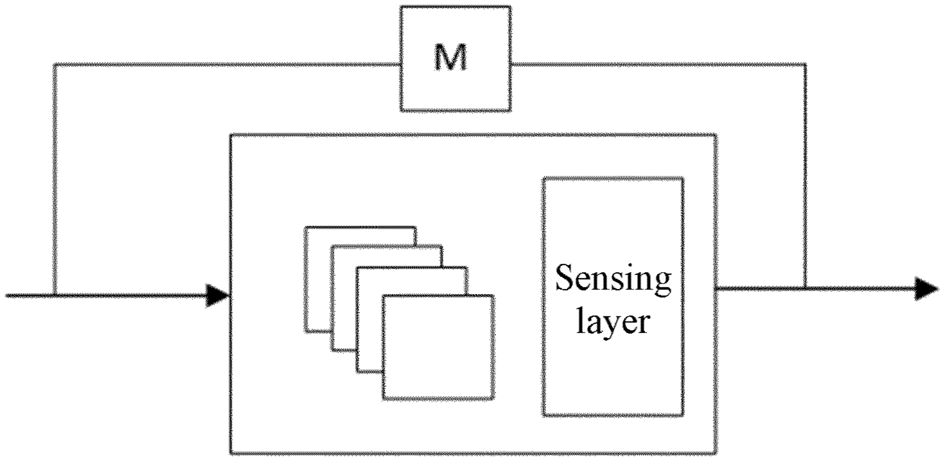
M
Sensing layer

FIG.2

**INTERNATIONAL SEARCH REPORT**

International application No.
**PCT/CN2023/117358**

**A. CLASSIFICATION OF SUBJECT MATTER**

G01R31/367(2019.01)i； G06F18/241(2023.01)i； G06F18/214(2023.01)i

According to International Patent Classification (IPC) or to both national classification and IPC

**B. FIELDS SEARCHED**

Minimum documentation searched (classification system followed by classification symbols)

IPC:G01R31 G06F18

Documentation searched other than minimum documentation to the extent that such documents are included in the fields searched

Electronic data base consulted during the international search (name of data base and, where practicable, search terms used)

CNABS, CNTXT, CNKI, 万方, WANFANG: 储能, 蓄能, 电站, 电池, 故障, 检, 测, 诊断, 神经网络, 残差, 感知, BRAN, 加权, 融合, 聚合, 温度, 电压, 电流, 环境, 特征提取, 分类, 损失函数, 标准化, 归一化, 全卷积神经网络, FCN VEN, USTXT, WOTXT, EPTXT: stored energy, energy storage, power plant, power station, battery, detect, measure, test, diagnosis, neural network, residual, aware, BRAN, weight, interfuse, confluence, temperature, voltage, current, environment, feature extraction, classify, rank, group, loss function, standardization, fully convolutional neural network, FCN

**C. DOCUMENTS CONSIDERED TO BE RELEVANT**

| Category* | Citation of document, with indication, where appropriate, of the relevant passages | Relevant to claim No. |
|---|---|---|
| PX | CN 116577673 A (SHENZHEN NATIONAL ENGINEERING RESEARCH CENTER OF ADVANCED ENERGY STORAGE MATERIALS CO., LTD.) 11 August 2023 (2023-08-11) claims 1-10 | 1-10 |
| A | CN 115825756 A (CHINA HUANENG GROUP CLEANING ENERGY TECHNOLOGY RESEARCH INSTITUTE CO., LTD. et al.) 21 March 2023 (2023-03-21) description, paragraphs 21-44 | 1-10 |
| A | CN 112132264 A (INSTITUTE OF ARTIFICIAL INTELLIGENCE HEFEI COMPREHENSIVE NATIONAL SCIENCE CENTER (ANHUI ARTIFICIAL INTELLIGENCE LABORATORY)) 25 December 2020 (2020-12-25) description, paragraphs 100-121 | 1-10 |
| A | CN 113608140 A (SISHUI POWER SUPPLY COMPANY OF STATE GRID SHANDONG ELECTRIC POWER CO. et al.) 05 November 2021 (2021-11-05) entire document | 1-10 |

☑ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **29 February 2024** | **15 March 2024** |
| Name and mailing address of the ISA/CN<br>**China National Intellectual Property Administration (ISA/CN)**<br>**China No. 6, Xitucheng Road, Jimenqiao, Haidian District, Beijing 100088** | Authorized officer<br><br>Telephone No. |

Form PCT/ISA/210 (second sheet) (July 2022)

**INTERNATIONAL SEARCH REPORT**

International application No.
**PCT/CN2023/117358**

**C. DOCUMENTS CONSIDERED TO BE RELEVANT**

| Category* | Citation of document, with indication, where appropriate, of the relevant passages | Relevant to claim No. |
|---|---|---|
| A | CN 116317937 A (SHAOXING POWER SUPPLY CO., STATE GRID ZHEJIANG ELECTRIC POWER CO., LTD.) 23 June 2023 (2023-06-23)<br>entire document | 1-10 |
| A | CN 111080533 A (NANJING UNIVERSITY OF AERONAUTICS AND ASTRONAUTICS) 28 April 2020 (2020-04-28)<br>entire document | 1-10 |
| A | CN 115765107 A (QIDONG WOTAI NEW ENERGY CO., LTD.) 07 March 2023 (2023-03-07)<br>entire document | 1-10 |
| A | CN 110045292 A (DONGGUAN UNIVERSITY OF TECHNOLOGY) 23 July 2019 (2019-07-23)<br>entire document | 1-10 |
| A | CN 113642383 A (HARBIN UNIVERSITY OF SCIENCE AND TECHNOLOGY) 12 November 2021 (2021-11-12)<br>entire document | 1-10 |
| A | WO 2022173384 A1 (EATRON YAZILIM VE MUHENDISLIK TEKNOLOJILERI A. S.) 18 August 2022 (2022-08-18)<br>entire document | 1-10 |

Form PCT/ISA/210 (second sheet) (July 2022)

**INTERNATIONAL SEARCH REPORT**
**Information on patent family members**

International application No.
**PCT/CN2023/117358**

| Patent document cited in search report | | | Publication date (day/month/year) | Patent family member(s) | | | Publication date (day/month/year) |
|---|---|---|---|---|---|---|---|
| CN | 116577673 | A | 11 August 2023 | CN | 116577673 | B | 12 September 2023 |
| CN | 115825756 | A | 21 March 2023 | CN | 115825756 | B | 16 May 2023 |
| CN | 112132264 | A | 25 December 2020 | CN | 112132264 | B | 07 April 2023 |
| CN | 113608140 | A | 05 November 2021 | | None | | |
| CN | 116317937 | A | 23 June 2023 | | None | | |
| CN | 111080533 | A | 28 April 2020 | CN | 111080533 | B | 16 May 2023 |
| CN | 115765107 | A | 07 March 2023 | | None | | |
| CN | 110045292 | A | 23 July 2019 | | None | | |
| CN | 113642383 | A | 12 November 2021 | | None | | |
| WO | 2022173384 | A1 | 18 August 2022 | EP | 4291908 | A1 | 20 December 2023 |

Form PCT/ISA/210 (patent family annex) (July 2022)